# FASCICULE DE BREVET EUROPEEN

(11) **EP 2 864 196 B1**
(45) Date de publication et mention de la délivrance du brevet: **17.08.2016**
(21) Numéro de dépôt: 13733987.5
(22) Date de dépôt: 21.06.2013
(51) Int. Cl.: B64C 25/24, H02H 3/02, H03K 19/007

(54) **CIRCUIT ELECTRIQUE DE COUPURE D'UNE ALIMENTATION ELECTRIQUE A TRANSISTORS ET FUSIBLES**
ELEKTRISCHE SCHALTUNG ZUM ABSCHALTEN EINER ELEKTRISCHEN STROMVERSORGUNG MIT TRANSISTOREN UND SCHMELZSICHERUNGEN
ELECTRIC CIRCUIT FOR CUTTING OFF AN ELECTRIC POWER SUPPLY HAVING TRANSISTORS AND FUSES

(30) Priorité: 21.06.2012 FR 1255871
(43) Date de publication de la demande: 29.04.2015
(73) Titulaire: Safran Electronics & Defense, 92100 Boulogne-Billancourt (FR)
(72) Inventeur: VALETTE, Patrick, F-92100 Boulogne-Billancourt (FR); GUILLOT, François, F-92100 Boulogne-Billancourt (FR)
(74) Mandataire: Regimbeau
(86) Numéro de dépôt international: PCT/EP2013/062990
(87) Numéro de publication internationale: WO 2013/190087

(56) Documents cités:
- WO-A1-2011/107216
- WO-A2-2008/113337

## Description

### DOMAINE TECHNIQUE GENERAL

L'invention concerne le domaine de la sécurité de la commande de systèmes ou d'équipements, notamment électroniques et notamment ceux embarqués à bord d'un aéronef.

### ETAT DE LA TECHNIQUE

Un système électrique peut être commandé après qu'une condition est vérifiée. Le document WO 2008/113337 A2, (voir le preambule de la revendication 1), décrit un tel système.

Une solution connue est de connecter l'alimentation du système électrique à un circuit électrique configuré pour tester des signaux discrets indiquant qu'une condition est vérifiée.

Par exemple, dans le cas d'un aéronef, certains équipements électriques doivent être coupés en vol, par exemple dans le cas d'un système d'acquisition, de traitement et de communication de données avioniques, le module radio de transmission sans fil doit être coupé pour ne pas perturber le fonctionnement de l'aéronef.

Au moyen de portes logiques ET (en anglais, « AND ») connectées à des interrupteurs il est possible simplement de couper l'alimentation du module radio si nécessaire.

Une telle solution n'est toutefois pas satisfaisante lorsque des niveaux de sécurité (en anglais, « *safety* ») particulièrement élevés sont requis. Par exemple, les niveaux de fiabilité requis pour l'alimentation des équipements électriques présentant un risque catastrophique, c'est-à-dire menant potentiellement à la perte de vies humaines, sont de l'ordre de 10⁻⁹ par heure de vol.

### PRESENTATION DE L'INVENTION

L'invention propose de pallier au moins un de ces inconvénients.

A cet effet, l'invention propose un circuit électrique adapté pour couper une alimentation électrique d'un équipement électrique, ledit circuit électrique recevant en entrée au moins deux signaux électriques discrets dont les valeurs conditionnent l'alimentation de l'équipement électrique, les signaux électriques discrets présentant un état haut si l'équipement électrique doit être alimenté,
- le circuit électrique comprenant une source de tension ;
- une première unité de coupure connectée entre l'équipement électrique et la source de tension, la première unité de coupure présentant un état ouvert ou fermé en fonction des signaux électriques discrets ;
- une seconde unité de coupure connectée à l'intersection entre l'équipement électrique et la première unité de coupure, et à une ligne de masse, la seconde unité de coupure présentant un état complémentaire à la première unité de coupure si les signaux électriques discrets sont dans un état identiques, la seconde unité de coupure comprenant un montage parallèle d'au moins deux interrupteurs, ledit montage parallèle étant connecté à la source d'alimentation, l'état de chacun des deux interrupteurs étant fonction d'un signal électrique discret, les interrupteurs étant dans un même état lorsque les signaux électriques discrets sont dans un état identique, lesdites première et seconde unité de coupure étant commandées pour générer un court-circuit en cas de divergence entre les signaux électriques discrets, au moins deux interrupteurs de la seconde unité de coupure présentant des états divergents l'un par rapport à l'autre afin de générer ledit court-circuit.

L'invention est avantageusement complétée par les caractéristiques suivantes, prises seules ou en une quelconque de leur combinaison techniquement possible :
- la seconde unité de coupure comprend un montage parallèle d'au moins deux interrupteurs, le montage parallèle étant connecté à la source d'alimentation, l'état de chacun des deux interrupteurs étant fonction d'un signal électrique discret, la seconde unité de coupure comprenant autant d'interrupteurs que de signaux électriques discrets ;
- les interrupteurs du montage parallèle présentent un état ouvert ou fermé en fonction d'un signal électrique de commande, les interrupteurs étant à l'état ouvert si le signal électrique de commande présente un état « haut » et à l'état fermé si le signal électrique de commande présentent un état « bas » ;
- la première unité de coupure comprend un premier interrupteur présentant un état ouvert ou fermé en fonction d'un signal électrique de commande fonction des signaux électriques discrets, le premier interrupteur étant à l'état ouvert si le signal électrique de commande présente un état « bas » et est à l'état fermé si le signal électrique de commande présente un état « haut » ;
- le premier interrupteur est commandé par une fonction logique des signaux discrets du type 'OU' logique ;
- la première unité de coupure comprend un second interrupteur, le second interrupteur présentant un état ouvert ou fermé en fonction d'un signal électrique de commande fonction des signaux électriques discrets le second interrupteur étant à l'état ouvert si le signal électrique de commande présente un état « bas » et est à l'état fermé si le signal électrique de commande présente un état « haut », ledit second interrupteur étant adapté pour isoler la source de tension de l'alimentation électrique si les signaux électriques discrets sont à l'état bas ;
- le second interrupteur est commandé par une fonction logique des signaux électriques discrets du type 'ET' logique ;
- il comprend au moins un fusible pour, en cas de court-circuit isoler la source de tension des éléments dudit circuit électrique ;
- il comprend une unité de test pour détecter une défaillance d'au moins un composant du circuit et le cas échéant commander les première et seconde unités de coupure pour générer un court-circuit.
- l'unité de test est adaptée pour mettre en oeuvre les étapes consistant à : isoler l'équipement électrique du circuit électrique ; commander la seconde unité de coupure pour que cette dernière soit à l'état fermé ; mesurer une tension entre la première unité de coupure et la seconde unité de coupure pour vérifier que la seconde unité de coupure est adaptée pour générer un court-circuit ;
- l'unité de test est adaptée pour mettre en oeuvre les étapes consistant à : commander la première unité de coupure pour que cette dernière soit à l'état fermé ; mesurer une tension aux bornes de la deuxième unité de coupure, une tension égale à la tension délivrée par la source de tension indiquant que la première unité de coupure fonctionne ; commander la première unité de coupure pour que cette dernière soit à l'état ouvert ; mesurer une tension aux bornes de la deuxième unité de coupure, une tension, une tension nulle indiquant que la première unité de coupure fonctionne ;
- l'unité de test est implémentée au moyen de composants logiques programmables ou au moyen de microcontrôleurs qui peuvent intégrer des moyens de mesures de tensions analogiques pour enrichir le niveau de surveillance du circuit.

Et l'invention concerne également un système d'acquisition, de traitement et de communication de données avioniques comprenant un module radio connecté à un circuit électrique selon l'invention.

Le circuit de l'invention comportant plusieurs composants le niveau de sécurité du circuit est de l'ordre de 10⁻⁹. En outre, en utilisant plusieurs étages qui peuvent interagir en fonction de leur état on s'assure que le circuit est robuste aux pannes qui peuvent affecter les composants tout en permettant d'alimenter l'équipement électrique seulement dans les cas où il doit l'être.

Ainsi, on obtient un circuit qui peut s'autodétruire en cas de panne des composants.

Le niveau de fiabilité atteint est tel qu'il n'est pas nécessaire de surveiller préventivement le bon fonctionnement du circuit car le niveau de redondance est tel qu'il est statistiquement impossible que l'ensemble de pannes résultant en une mise alimentation de l'équipement électrique, non désirée, puisse se produire sur une période de trente ans et plus.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1 illustre un système d'acquisition, de traitement et de communication de données avioniques conformes à un mode de réalisation de l'invention ;
- la figure 2 illustre un schéma de principe d'un circuit électrique conforme à un premier mode de réalisation de l'invention,
- la figure 3 illustre un schéma de principe d'un circuit électrique conforme à seconde un mode de réalisation de l'invention ;
- la figure 4 illustre un schéma électrique d'un circuit électrique conforme à un mode de réalisation de l'invention.

Sur l'ensemble des figures, les éléments similaires portent des références identiques.

### DESCRIPTION DETAILLEE DE L'INVENTION

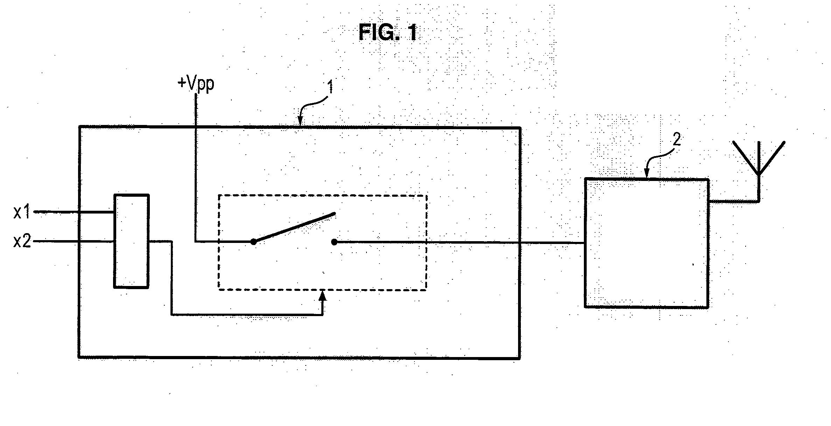

En relation avec la figure 1, un système d'acquisition, de traitement et de communication de données avioniques comprend :
- une unité d'acquisition (non représentée) de signaux électriques discrets x1, x2 indiquant un état de l'aéronef ;
- un module 2 radio adapté pour transférer les données avioniques du système vers une station distante ;
- une source de tension +Vpp d'alimentation du module 2 radio, et
- un circuit 1 électrique d'alimentation électrique du module 2 radio qui permet de couper l'alimentation du module radio lorsque l'aéronef est en vol.

Un état de l'aéronef est par exemple, en vol, au sol, etc. Lorsque l'aéronef est au sol des signaux électriques discrets indiquant que l'aéronef a atterri sont par exemple : un signal indiquant l'existence d'un poids de l'aéronef sur les roues, ou bien un signal indiquant que les portes de l'aéronef sont ouvertes.

Le circuit électrique d'alimentation peut être modélisé par un interrupteur commandé par une fonction logique des signaux électriques discrets (voir la figure 1).

On précise que l'on entend par fonction logique une série d'opérations logiques à une ou plusieurs variables. Des fonctions logiques connues sont : ET (en anglais, « AND »), OU (en anglais, « OR »), OU exclusif (en anglais, « XOR »), etc.

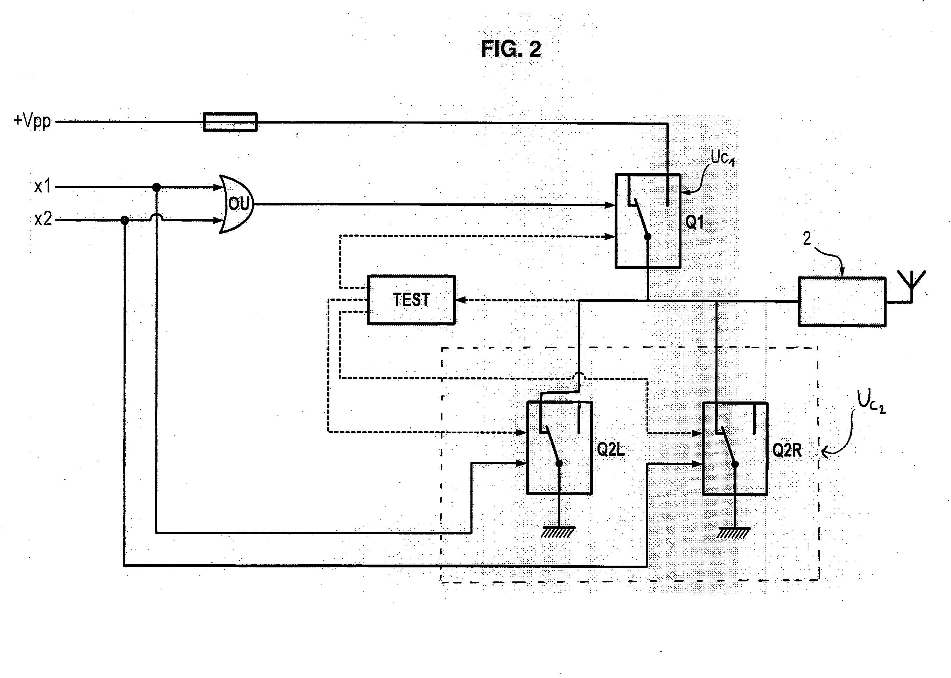

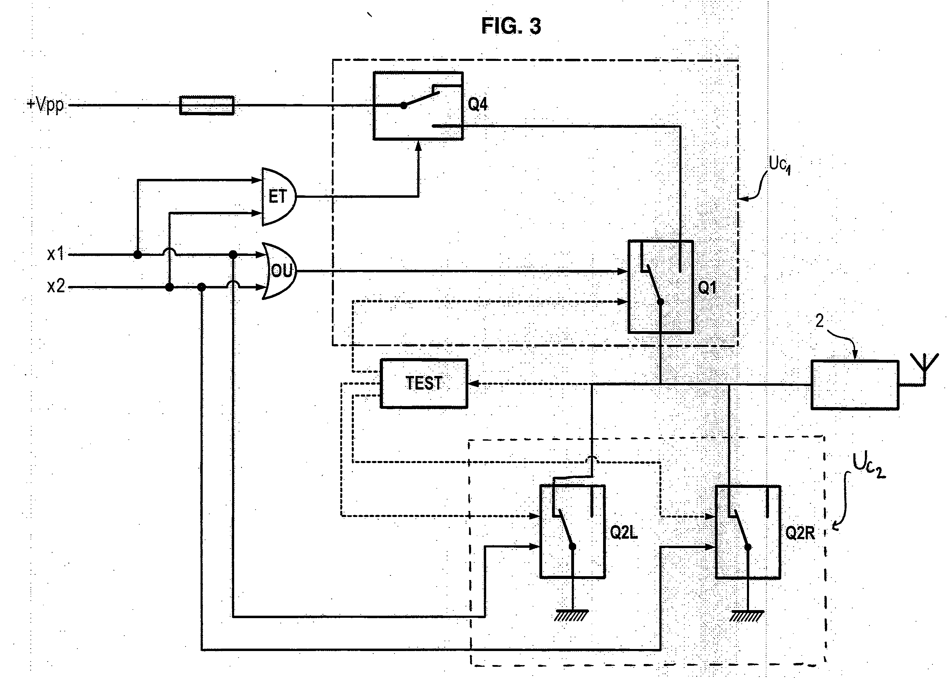

En relation avec la figure 2, le circuit 1 électrique reçoit en entrée au moins deux signaux électriques discrets, de préférence trois signaux électriques discrets x1, x2 et comprend une source de tension +Vpp. Les valeurs des signaux électriques discrets conditionnent l'alimentation électrique du module 2 radio. En l'occurrence, dans le mode de réalisation des figures 2 et 3, les signaux électriques discrets doivent tous être égaux à 1 pour que le module 2 radio soit alimenté.

Bien entendu, on peut envisager un circuit électrique recevant en entrée un nombre plus élevé de signaux électriques discrets.

Le circuit électrique permet en fonctionnement normal d'alimenter l'alimentation électrique de l'équipement électrique 2 en fonction des valeurs des signaux électriques discrets.

On considère dans ce qui suit les valeurs logiques des signaux électriques discrets. En particulier, on considère qu'un signal électrique discret présente un état haut, c'est-à-dire une valeur logique '1' s'il traduit une condition selon laquelle l'équipement électrique peut être alimenté (par exemple, si l'aéronef a atterri) et qu'il est présente un état bas, c'est-à-dire une valeur logique '0' s'il traduit une condition selon laquelle l'équipement électrique ne doit pas être alimenté.

En relation avec les figures 2 et 3, on considère que les signaux électriques discrets doivent tous les trois êtres à l'état haut si l'équipement électrique 2 doit être alimenté.

Comme cela sera décrit dans ce qui suit, si un seul composant est utilisé pour tester les valeurs des signaux discrets ce dernier présente une probabilité de défaillance qui n'est pas négligeable de sorte que l'équipement électrique est alimenté alors qu'il ne devrait pas l'être.

Pour pallier ce problème, le circuit électrique présente plusieurs étages qui interagissent entre eux. A chaque étage, on peut prévenir une défaillance des composants qui présente un état incohérent avec les signaux discrets.

Ceci permet de diminuer la probabilité d'alimenter l'équipement électrique alors qu'il ne devrait pas l'être.

En effet, la probabilité de défaillance du circuit doit être de l'ordre de 10⁻⁹ alors qu'un composant électronique seul a une probabilité de défaillance de l'ordre de 10⁻⁶.

Le circuit 1 logique comprend une source de tension +Vpp qui alimente l'équipement électrique si tous les signaux discrets indiquent que l'équipement électrique doit l'être. Par exemple, l'aéronef a atterri les signaux discrets x1, x2 valent tous les deux '1' et valent '0' si ce n'est pas le cas.

Une première de coupure Uc1 est connectée à la source de tension +Vpp et présente un état ouvert si les signaux électriques discrets indiquent que l'équipement électrique ne doit pas être alimenté et un état fermé si les signaux électriques discrets indiquent que l'équipement électrique doit l'être.

Une seconde unité de coupure Uc2 est connectée à l'intersection entre l'équipement 2 électrique et la première unité Uc1 de coupure, et à une ligne de masse. La seconde unité Uc2 de coupure présente un état complémentaire à la première unité de coupure Uc1 si les signaux électriques discrets x1, x2 présentent un état identique. La seconde unité Uc2 de coupure est connectée à une ligne de masse.

En revanche, dès lors que les signaux discrets x1, x2 présentent un état divergent, les première et secondes unités de coupure sont commandées pour générer un court-circuit.

En particulier, la première unité de coupure Uc1, en cas de divergence des signaux électriques discrets est dans un état fermé, et la second unité de coupure Uc1 va générer le court-circuit.

De manière avantageuse, la première unité de coupure Uc1 comprend un premier interrupteur Q1 présentant un état ouvert ou fermé en fonction d'un signal électrique de commande fonction des signaux électriques discrets. Le premier interrupteur Q1 est à l'état ouvert si le signal électrique de commande présente un état « bas » et est à l'état fermé si le signal électrique de commande présente un état « haut ».

Le premier interrupteur Q1 est notamment commandé par une fonction logique des signaux discrets du type 'OU' logique.

En outre, la seconde unité Uc2 de coupure comprend un montage parallèle d'au moins deux interrupteurs Q2L, Q2R, le montage parallèle étant connecté à la source d'alimentation, l'état de chacun des deux interrupteurs étant fonction d'un signal électrique discret x1, x2. On note que la seconde unité de coupure Uc2 comprend autant d'interrupteurs que de signaux électriques discrets x1, x2.

Chaque interrupteur Q2L, Q2R est respectivement commandé par un signal électrique discret reçu en entrée. Ainsi, en relation avec les figures 2 à 4, le signal électrique discret x1 commande l'interrupteur Q2L et le signal électrique discret x2 commande l'interrupteur Q2R.

En outre, les interrupteurs Q2L, Q2R sont dans un même état lorsque les signaux électriques discrets x1, x2 sont dans un état identique, et les première et seconde unité de coupure sont commandées pour générer un court-circuit en cas de divergence entre les signaux électriques discrets x1, x2, au moins deux interrupteurs de la seconde unité de coupure présentent des états divergents l'un par rapport à l'autre afin de générer le court-circuit, la première unité de coupure Uc1 étant dans un état fermé pour laisser passer la tension issue de la source de tension.

De manière complémentaire (voir la figure 3), la première unité de coupure Uc1 comprend en outre un second interrupteur Q4, commandé par une fonction logique des signaux électriques discrets du type 'ET' logique.

Enfin, le circuit électrique comprend également un fusible FUSE pour en cas de court-circuit isoler la source de tension +Vpp des éléments du circuit 1 logique. En cas de court-circuit le fusible +Vpp se met à fondre pour protéger le circuit.

Ainsi, dans le mode de réalisation de la figure 2, on a par exemple :
- si x1=x2='0' : l'interrupteur Q1 est ouvert, les deux interrupteurs Q2R, Q2L sont fermés. Il n'y a pas de court-circuit, l'équipement électrique n'est pas alimenté.
- si x1=x2='1' : l'interrupteur Q1 est fermé, les deux interrupteurs Q2R, Q2L sont ouverts. L'équipement électrique est alimenté.
- si x1='0 et x2='1' ou x1='1' et x2='0' : il y a une divergence entre les signaux électriques discrets, l'interrupteur Q1 est fermé et l'un ou l'autre des interrupteurs Q2L ou Q2R est fermé. Il y a alors un court-circuit.

En outre, en cas de défaillance de l'interrupteur Q1 qui peut être fermé alors qu'il devrait être ouvert (compte tenu des signaux électriques discrets x1, x2), la seconde unité de coupure permettra de provoquer un court-circuit, l'équipement électrique ne sera pas alimenté.

Ainsi, comme la seconde unité de coupure Uc2 permet de surveiller le circuit d'alimentation. Il en va de même si la première unité de coupure Uc1 comprend un second interrupteur Q4.

En outre, dans la mesure où il est peu probable que tous les composants du circuit présentent en même temps une défaillance, le circuit prévient donc des défaillances des composants logiques générant les commandes des différents éléments du circuit.

Dans le mode de réalisation de la figure 3, on a par exemple :
- si x1=x2='0' : l'interrupteur Q4 est ouvert, l'interrupteur Q1 est ouvert, les deux interrupteurs Q2R, Q2L sont fermés. Il n'y a pas de court-circuit, l'équipement électrique n'est pas alimenté.
- si x1=x2='1' : l'interrupteur Q4 est fermé, l'interrupteur Q1 est fermé, les deux interrupteurs Q2R, Q2L sont ouverts. L'équipement électrique est alimenté.
- si x1='0 et x2='1' ou x1='1' et x2='0' : il y a une divergence entre les signaux électriques discrets, l'interrupteur Q4 est fermé, l'interrupteur Q1 est fermé et l'un ou l'autre des interrupteurs Q2L ou Q2R est fermé. Il y a alors un court-circuit.

De manière complémentaire, le circuit électrique comprend une unité de test TEST qui permet de vérifier la capacité du circuit à provoquer un court-circuit. Cette vérification peut être programmée pour être lancée périodiquement quand l'équipement 2 électrique n'est pas alimenté.

En particulier, l'unité de test TEST permet de détecter une défaillance d'au moins un composant du circuit et le cas échéant commander les première et seconde unités de coupure pour générer un court-circuit.

S'agissant de la seconde unité de coupure Uc2, l'unité de test est en particulier adaptée pour mettre en oeuvre les étapes consistant à
- isoler l'équipement électrique du circuit électrique
- commander la seconde unité de coupure Uc2 pour que cette dernière soit à l'état fermé ;
- mesurer une tension entre la première unité de coupure et la seconde unité de coupure pour vérifier que la seconde unité de coupure est adaptée pour générer un court-circuit, une tension nulle indiquant que la seconde unité de coupure fonctionne.

S'agissant de la première unité de coupure Uc1, l'unité de test est en particulier adaptée pour mettre en oeuvre les étapes consistant à
- commander la première unité de coupure Uc1 pour que cette dernière soit à l'état fermé
- mesurer une tension aux bornes de la deuxième unité de coupure Uc2, une tension égale à la tension délivrée par la source de tension +Vpp indiquant que la première unité de coupure fonctionne ;
- commander la première unité de coupure Uc1 pour que cette dernière soit à l'état ouvert,
- mesurer une tension aux bornes de la première deuxième unité de coupure Uc2, une tension, une tension nulle indiquant que la première unité de coupure fonctionne.

Enfin s'agissant de l'une ou l'autre des deux unités de coupure, si à l'issu des tests, une défaillance est détectée, alors on commande un court-circuit.

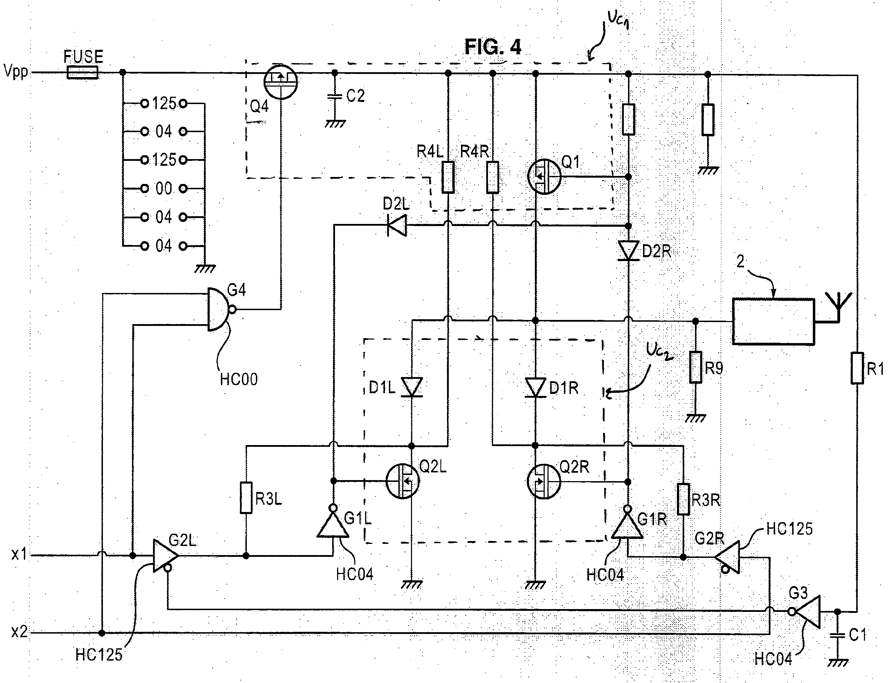

Selon un mode de réalisation, l'unité de test TEST peut être implémentée au moyen de composants logiques programmables (en anglais, *« Electronically Programmable Logic Devices* », (EPLD)) ou au moyen de microcontrôleurs qui peuvent intégrer des moyens de mesures de tensions analogiques pour enrichir le niveau de surveillance du circuit. En relation avec la figure 4 un circuit électrique selon une réalisation particulière est illustré.

Pour générer les commandes des interrupteurs Q2L et Q2R, le circuit 1 électrique comprend cinq unités logiques G3, G1 L, G1 R, G2R, G2L.

Les unités logiques G1 L et G2L concernent l'interrupteur Q2L, les unités logiques G1 R et G2R concernent quant à elles l'interrupteur Q2R, l'unité logique G3 étant commune aux interrupteurs Q2R et Q2L.

Les unités G2R, G3, G2L sont des portes logiques à trois états (en anglais, « *TriState* »).

L'unité logique G4 est une porte logique ET.

Bien entendu, on peut envisager d'autres possibilités pour générer les commandes du circuit.

Dans cette réalisation, les interrupteurs Q1 et Q4 sont des transistors CMOS à l'état fermé lorsque la commande est un '0' logique.

Les interrupteurs Q2L et Q2R sont des transistors CMOS à l'état fermé lorsque la commande est '1' logique.

## Revendications

1. Circuit électrique adapté pour couper une alimentation électrique d'un équipement (2) électrique, ledit circuit électrique recevant en entrée au moins deux signaux électriques discrets (x1, x2) dont les valeurs conditionnent l'alimentation de l'équipement (2) électrique, les signaux électriques discrets présentant un état haut ('1') si l'équipement électrique doit être alimenté,
- le circuit électrique comprenant une source de tension (+Vpp) ;
- une première unité (Uc1) de coupure connectée entre l'équipement (2) électrique et la source de tension (+Vpp), la première unité de coupure (Uc1) présentant un état ouvert ou fermé en fonction des signaux électriques discrets (x1, x2), **caractérisé par**
- une seconde unité (Uc2) de coupure connectée à l'intersection entre l'équipement électrique et la première unité (Uc1) de coupure, et à une ligne de masse, la seconde unité (Uc2) de coupure présentant un état complémentaire à la première unité de coupure si les signaux électriques discrets (x1, x2) sont dans un état identiques, la seconde unité de coupure (Uc2) comprenant un montage parallèle d'au moins deux interrupteurs (Q2L, Q2R), ledit montage parallèle étant connecté à la source d'alimentation, l'état de chacun des deux interrupteurs étant fonction d'un signal électrique discret (x1, x2), les interrupteurs étant dans un même état lorsque les signaux électriques discrets (x1, x2) sont dans un état identique, lesdites première et seconde unité de coupure étant commandées pour générer un court-circuit en cas de divergence entre les signaux électriques discrets, au moins deux interrupteurs de la seconde unité de coupure présentant des états divergents l'un par rapport à l'autre afin de générer ledit court-circuit.

2. Circuit électrique selon la revendication précédente, dans lequel la seconde unité de coupure (Uc2) comprend autant d'interrupteurs que de signaux électriques discrets.

3. Circuit électrique selon la revendication 2, dans lequel les interrupteurs du montage parallèle présentent un état ouvert ou fermé en fonction d'un signal électrique de commande, les interrupteurs étant à l'état ouvert si le signal électrique de commande présente un état « haut » et à l'état fermé si le signal électrique de commande présentent un état « bas ».

4. Circuit électrique selon l'une des revendications précédentes, dans lequel la première unité de coupure comprend un premier interrupteur (Q1) présentant un état ouvert ou fermé en fonction d'un signal électrique de commande fonction des signaux électriques discrets, le premier interrupteur étant à l'état ouvert si le signal électrique de commande présente un état « bas » et est à l'état fermé si le signal électrique de commande présente un état « haut ».

5. Circuit électrique selon la revendication précédente, dans lequel le premier interrupteur est commandé par une fonction logique des signaux discrets du type 'OU' logique.

6. Circuit électrique selon l'une des 4 à 5, dans lequel la première unité de coupure (Uc1) comprend un second interrupteur (Q4), le second interrupteur présentant un état ouvert ou fermé en fonction d'un signal électrique de commande fonction des signaux électriques discrets le second interrupteur étant à l'état ouvert si le signal électrique de commande présente un état « bas » et est à l'état fermé si le signal électrique de commande présente un état « haut », ledit second interrupteur (Q4) étant adapté pour isoler la source de tension de l'alimentation électrique si les signaux électriques discrets sont à l'état bas.

7. Circuit électrique selon la revendication 6, dans lequel le second interrupteur (Q4) est commandé par une fonction logique des signaux électriques discrets du type 'ET' logique.

8. Circuit électrique selon l'une des revendications précédentes, comprenant au moins un fusible (FUSE) pour, en cas de court-circuit isoler la source de tension (+Vpp) des éléments dudit circuit électrique.

9. Circuit électrique selon l'une des revendications précédentes, comprenant une unité (TEST) de test pour détecter une défaillance d'au moins un composant du circuit et le cas échéant commander les première et seconde unités de coupure pour générer un court-circuit.

10. Circuit électrique selon la revendication précédente, dans lequel l'unité de test est adaptée pour mettre en oeuvre les étapes consistant à :
- isoler l'équipement électrique du circuit électrique
- commander la seconde unité de coupure (Uc2) pour que cette dernière soit à l'état fermé ;
- mesurer une tension entre la première unité de coupure et la seconde unité de coupure pour vérifier que la seconde unité de coupure est adaptée pour générer un court-circuit.

11. Circuit électrique selon l'une des revendications 9 à 10, dans lequel l'unité de test (TEST) est adaptée pour mettre en oeuvre les étapes consistant à :
- commander la première unité de coupure (Uc1) pour que cette dernière soit à l'état fermé
- mesurer une tension aux bornes de la deuxième unité de coupure (Uc2), une tension égale à la tension délivrée par la source de tension (+Vpp) indiquant que la première unité de coupure fonctionne ;
- commander la première unité de coupure (Uc1) pour que cette dernière soit à l'état ouvert,
- mesurer une tension aux bornes de la deuxième unité de coupure (Uc1), une tension, une tension nulle indiquant que la première unité de coupure fonctionne.

12. Circuit électrique selon l'une des revendications 9 à 11, dans lequel l'unité de test (TEST) est implémentée au moyen de composants logiques programmables ou au moyen de microcontrôleurs qui peuvent intégrer des moyens de mesures de tensions analogiques pour enrichir le niveau de surveillance du circuit.

13. Système d'acquisition, de traitement et de communication de données avioniques comprenant un module (2) radio connecté à un circuit électrique selon l'une des revendications précédentes.

## Patentansprüche

1. Elektrischer Schaltkreis, der ausgebildet ist, um eine elektrische Versorgung einer elektrischen Ausrüstung (2) zu unterbrechen, wobei der elektrische Schaltkreis am Eingang mindestens zwei diskrete elektrische Signale (x1, x2) empfängt, deren Werte die Versorgung der elektrischen Ausrüstung (2) konditionieren, wobei die diskreten elektrischen Signale einen hohen Zustand ('1') aufweisen, wenn die elektrische Ausrüstung versorgt werden muss,
- wobei der elektrische Schaltkreis eine Spannungsquelle (+Vpp) umfasst,
- eine erste Unterbrechungseinheit (Uc1), die zwischen der elektrischen Ausrüstung (2) und der Spannungsquelle (+Vpp) geschaltet ist, wobei die erste Unterbrechungseinheit (Uc1) einen in Abhängigkeit von den diskreten elektrischen Signalen (x1, x2) geöffneten oder geschlossenen Zustand aufweist, **gekennzeichnet durch**
- eine zweite Unterbrechungseinheit (Uc2), die am Schnittpunkt zwischen der elektrischen Ausrüstung und der ersten Unterbrechungseinheit (Uc1) geschaltet und mit einer Erdungsleitung verbunden ist, wobei die zweite Unterbrechungseinheit (Uc2) einen Zustand aufweist, der zur ersten Unterbrechungseinheit komplementär ist, wenn die diskreten elektrischen Signale (x1, x2) in einem identischen Zustand sind, wobei die zweite Unterbrechungseinheit (Uc2) eine parallele Montage von mindestens zwei Schaltern (Q2L, Q2R) umfasst, wobei die parallele Montage mit der Versorgungsquelle verbunden ist, wobei der Zustand jedes der zwei Schalter von einem diskreten elektrischen Signal (x1, x2) abhängt, wobei die Schalter in einem gleichen Zustand sind, wenn die diskreten elektrischen Signale (x1, x2) in einem identischen Zustand sind, wobei die erste und zweite Unterbrechungseinheit gesteuert sind, um bei einer Divergenz zwischen den diskreten elektrischen Signalen einen Kurzschluss zu erzeugen, wobei mindestens zwei Schalter der zweiten Unterbrechungseinheit im Verhältnis zueinander divergierende Zustände aufweisen, um den Kurzschluss zu erzeugen.

2. Elektrischer Schaltkreis nach vorangehendem Anspruch, wobei die zweite Unterbrechungseinheit (Uc2) ebenso viele Schalter wie diskrete elektrische Signale umfasst.

3. Elektrischer Schaltkreis nach Anspruch 2, wobei die Schalter der parallelen Montage in Abhängigkeit von einem elektrischen Steuersignal einen geöffneten oder geschlossenen Zustand aufweisen, wobei die Schalter im geöffneten Zustand sind, wenn das elektrische Steuersignal einen "hohen" Zustand aufweist und im geschlossenen Zustand, wenn das elektrische Steuersignal einen "niedrigen" Zustand aufweist.

4. Elektrischer Schaltkreis nach einem der vorangehenden Ansprüche, wobei die erste Unterbrechungseinheit einen ersten Schalter (Q1) umfasst, der in Abhängigkeit von einem elektrischen Steuersignal als Funktion der diskreten elektrischen Signale einen geöffneten oder geschlossenen Zustand aufweist, wobei der erste Schalter im geöffneten Zustand ist, wenn das elektrische Steuersignal einen "niedrigen" Zustand aufweist und im geschlossenen Zustand ist, wenn das elektrische Steuersignal einen "hohen" Zustand aufweist.

5. Elektrischer Schaltkreis nach vorangehendem Anspruch, wobei der erste Schalter von einer logischen Funktion der diskreten Signale vom Typ logisches 'ODER' gesteuert wird.

6. Elektrischer Schaltkreis nach einem der Ansprüche 4 bis 5, wobei die erste Unterbrechungseinheit (Uc1) einen zweiten Schalter (Q4) umfasst, wobei der zweite Schalter in Abhängigkeit von einem elektrischen Steuersignal als Funktion der diskreten elektrischen Signale einen geöffneten oder geschlossenen Zustand aufweist, wobei der zweite Schalter im geöffneten Zustand ist, wenn das elektrische Steuersignal einen "niedrigen" Zustand aufweist und im geschlossenen Zustand ist, wenn das elektrische Steuersignal einen "hohen" Zustand aufweist, wobei der zweite Schalter (Q4) ausgebildet ist, um die Spannungsquelle von der elektrischen Versorgung zu isolieren, wenn die diskreten elektrischen Signale im niedrigen Zustand sind.

7. Elektrischer Schaltkreis nach Anspruch 6, wobei der zweite Schalter (Q4) von einer logischen Funktion der diskreten elektrischen Signale vom Typ logisches 'UND' gesteuert wird.

8. Elektrischer Schaltkreis nach einem der vorangehenden Ansprüche, umfassend mindestens eine Sicherung (FUSE), um im Kurzschlussfall die Spannungsquelle (+Vpp) von den Elementen des elektrischen Schaltkreises zu isolieren.

9. Elektrischer Schaltkreis nach einem der vorangehenden Ansprüche, umfassend eine Testeinheit (TEST), um eine Fehlfunktion mindestens eines Bauteils des Schaltkreises festzustellen und um gegebenenfalls die erste und zweite Unterbrechungseinheit anzuweisen, einen Kurzschluss zu erzeugen.

10. Elektrischer Schaltkreis nach vorangehendem Anspruch, wobei die Testeinheit ausgebildet ist, um die folgenden Schritte umzusetzen:
- Isolieren der elektrischen Ausrüstung des elektrischen Schaltkreises,
- Steuern der zweiten Unterbrechungseinheit (Uc2), damit sich diese im geschlossenen Zustand befindet,
- Messen einer Spannung zwischen der ersten Unterbrechungseinheit und der zweiten Unterbrechungseinheit, um zu überprüfen, dass die zweite Unterbrechungseinheit für die Erzeugung eines Kurzschlusses geeignet ist.

11. Elektrischer Schaltkreis nach einem der Ansprüche 9 bis 10, wobei die Testeinheit (TEST) ausgebildet ist, um die folgenden Schritte umzusetzen:
- Steuern der ersten Unterbrechungseinheit (Uc1), damit sich diese im geschlossenen Zustand befindet,
- Messen einer Spannung an den Klemmen der zweiten Unterbrechungseinheit (Uc2), wobei eine Spannung, welche der von der Spannungsquelle (+Vpp) bereitgestellten Spannung entspricht, bedeutet, dass die erste Unterbrechungseinheit funktioniert,
- Steuern der ersten Unterbrechungseinheit (Uc1), damit sich diese im geöffneten Zustand befindet,
- Messen einer Spannung an den Klemmen der zweiten Unterbrechungseinheit (Uc1), wobei eine Spannung Null bedeutet, dass die erste Unterbrechungseinheit funktioniert.

12. Elektrischer Schaltkreis nach einem der Ansprüche 9 bis 11, wobei die Testeinheit (TEST) mit Hilfe programmierbarer logischer Komponenten oder mit Hilfe von Microcontrollern implementiert ist, die analoge Spannungsmessmittel integrieren können, um das Überwachungsniveau des Schaltkreises zu bereichern.

13. Erfassungs-, Verarbeitungs- und Kommunikationssystem von Avionikdaten, umfassend ein Funkmodul (2), das mit einem elektrischen Schaltkreis nach einem der vorangehenden Ansprüche verbunden ist.

## Claims

1. An electric circuit adapted to cut-off a power supply of an electrical equipment (2), said electric circuit receiving as input at least two discrete electrical signals (x1, x2) which values determine the power supply of the electrical equipment (2), the discrete electrical signals having a high state ('1') if the electrical equipment is to be power supplied,
- the electric circuit comprising a voltage source (+Vpp);
- a first cut-off unit (Uc1) connected between the electrical equipment (2) and the voltage source (+Vpp), the first cut-off unit (Uc1) having an open or closed state based on discrete electrical signals (x1, x2), **characterized by**
- a second cut-off unit (Uc2) connected to the intersection of the electrical equipment and the first cut-off unit (Uc1), and to a ground line, the second cut-off unit (Uc2) having an complementary state to the first cut-off unit if the discrete electrical signals (x1, x2) are in a same state, the second cut-off unit (Uc2) comprising a parallel arrangement of at least two switches (Q2L, Q2R), said parallel arrangement being connected to the power source, the state of each of the two switches is a function of a discrete electrical signal (x1, x2), the switches being in the same state when the discrete electrical signals (x1, x2) are in the same state, said first and second cut-off units being controlled to generate a short-circuit in case of discrepancy between the discrete electrical signals, at least two switches of the second cut-off unit having divergent states one from another to generate said short-circuit.

2. The electric circuit according to claim 1, wherein the second cut-off unit (Uc2) comprises as many switches as discrete electrical signals.

3. The electric circuit according to claim 2, wherein the switches of the parallel arrangement have an open or closed state depending on an electric control signal, the switches being in the open state if the electric control signal has a "high" state and in the closed state if the electric control signal has a "low" state.

4. The electric circuit according to any of the previous claims, wherein the first cut-off unit comprises a first switch (Q1) having an open or closed state depending on an electric control signal based on discrete electrical signals, the first switch being in the open state if the electric control signal has a "low" state and is in the closed state if the electric control signal has a "high" state.

5. The electric circuit according to the previous claim, wherein the first switch is controlled by a logical function of the discrete electric signals of logic type 'OR'.

6. The electric circuit according to any of claims 4 to 5, wherein the first cut-off unit (Uc1) comprises a second switch (Q4), the second switch having an open or closed state depending on an electric control signal based on discrete electrical signals, the second switch being in the open state if the electric control signal has a "low" state and is in the closed state if the electric control signal has a "high" state, said second switch (Q4) being adapted to isolate the voltage source from the power supply if the discrete electrical signals are in the low state.

7. The electric circuit according to claim 6, wherein the second switch (Q4) is controlled by a logical function of the discrete electrical signals of the type logic 'AND'.

8. The electric circuit according to any of the previous claims, comprising at least one fuse (FUSE) for isolating, in case of short-circuit, the voltage source (+Vpp) of the elements of said electric circuit.

9. The electric circuit according to any of the preceding claims, comprising a test unit (TEST) for detecting a failure of at least one component of the circuit and optionally controlling the first and second cut-off units to generate a short-circuit.

10. The electric circuit according to the previous claim, wherein the test unit is adapted to implement the steps of:
- isolating the electrical equipment of the electric circuit;
- controlling the second cut-off unit (Uc2) so that the latter is in the closed state;
- measuring a voltage between the first cut-off unit and the second cut-off unit to verify that the second cut-off unit is adapted to generate a short-circuit.

11. The electric circuit according to any of claims 9 to 10, wherein the test unit (TEST) is adapted to implement the steps of:
- controlling the first cut-off unit (Uc1) for the latter is in the closed state;
- measuring a voltage at the terminals of the second cut-off unit (Uc2), a voltage equal to the voltage supplied by the voltage source (+Vpp) indicating that the first cut-off unit is operating;
- controlling the first cut-off unit (Uc1) for the latter is in the open state;
- measuring a voltage at the terminals of the second cut-off unit (Uc1), a zero voltage indicating that the first cut-off unit is operating.

12. The electric circuit according to any of claims 9 to 11, wherein the test unit (TEST) is implemented using programmable logic components or using microcontrollers which can incorporate means of analog voltage measurements for enriching the circuit supervision level.

13. An avionic data acquisition, processing and communication system comprising a radio module (2) connected to an electric circuit according to any of the previous claims.
